Europäisches Patentamt

European Patent Office

Office européen des brevets

(19)

(11) Publication number: **0 220 108**
**A2**

## (12) EUROPEAN PATENT APPLICATION

(21) Application number: **86402221.5**

(22) Date of filing: **07.10.86**

(51) Int. Cl.⁴: **H 01 L 21/225**
**H 01 L 21/76**

(30) Priority: **07.10.85 US 785196**

(43) Date of publication of application:
**29.04.87 Bulletin 87/18**

(84) Designated Contracting States:
**AT DE FR GB IT NL**

(71) Applicant: **THOMSON COMPONENTS-MOSTEK
CORPORATION**
**1310 Electronics Drive**
**Carrollton Texas 75006(US)**

(72) Inventor: **Chan, Tsiu C.**
**THOMSON-CSF SCPI 19, avenue de Messine**
**F-75008 Paris(FR)**

(72) Inventor: **Han, Yu-Pin**
**THOMSON-CSF SCPI 19, avenue de Messine**
**F-75008 Paris(FR)**

(74) Representative: **Ruellan-Lemonnier, Brigitte et al,**
**THOMSON-CSF SCPI 19, avenue de Messine**
**F-75008 Paris(FR)**

(54) **Side-wall doping for trench isolation.**

(57) An improved method of trench isolation for silicon integrated circuits involves the use of a polysilicon trench filler material doped two orders of magnitude more heavily than the substrate and with the same polarity. A layer of dopant diffuses through a thin oxide layer lining the trench and into the substrate, this forming a channel stop along the trench surface.

FIG.2

EP 0 220 108 A2

- 1 -

## Description

## Side-Wall Doping For Trench Isolation

### Technical Field

The field of the invention is the fabrication of integrated circuits having trenches in the substrate for isolation of the integrated circuit elements.

### Background Art

The use of trenches for isolation of elements on integrated circuits has been studied for some years. A convenient summary is an article by R. D. Rung entitled "Trench Isolation Prospects for Application in CMOS VLSI". This article appeared in the IEDM 84 Conference in 1984. This article indicates that there is a significant problem associated with the trench isolation process in that it is not practical to perform what is essentially a field implant of the trench bottom and/or side-wall to prevent inversion of the substrate and the formation of parasitic channels. This problem has been addressed by the present invention.

### Disclosure of Invention

The invention relates to an improved integrated circuit fabrication process for trench isolation in which the side and bottom of the trench receive an effective field implant by diffusion of an impurity through a thin oxide coating lining the walls of the trench.

- 2 -

Brief Description of Drawings

Fig. 1 illustrates a top view of portion of an integrated circuit constructed according to the invention.

Fig. 2 illustrates a cross section of one element of the invention.

Fig. 3 illustrates a cross section of a different view of the elements shown in Fig. 1.

Figs. 4a and 4b illustrate intermediate steps in the fabrication of a trench according to the invention.

Fig. 5 illustrates a portion of a CMOS circuit employing the invention.

Best Mode of Carrying Out the Invention

The importance of having a field implant or doping under oxide isolation in order to prevent the formation of parasitic channels is long established in the art. Previous work on trench isolation, in contrast to the planar isolation that is standard in industry practice, has been troubled by the difficulty in performing something equivalent to a field implant in order to suppress similar parasitic channels.

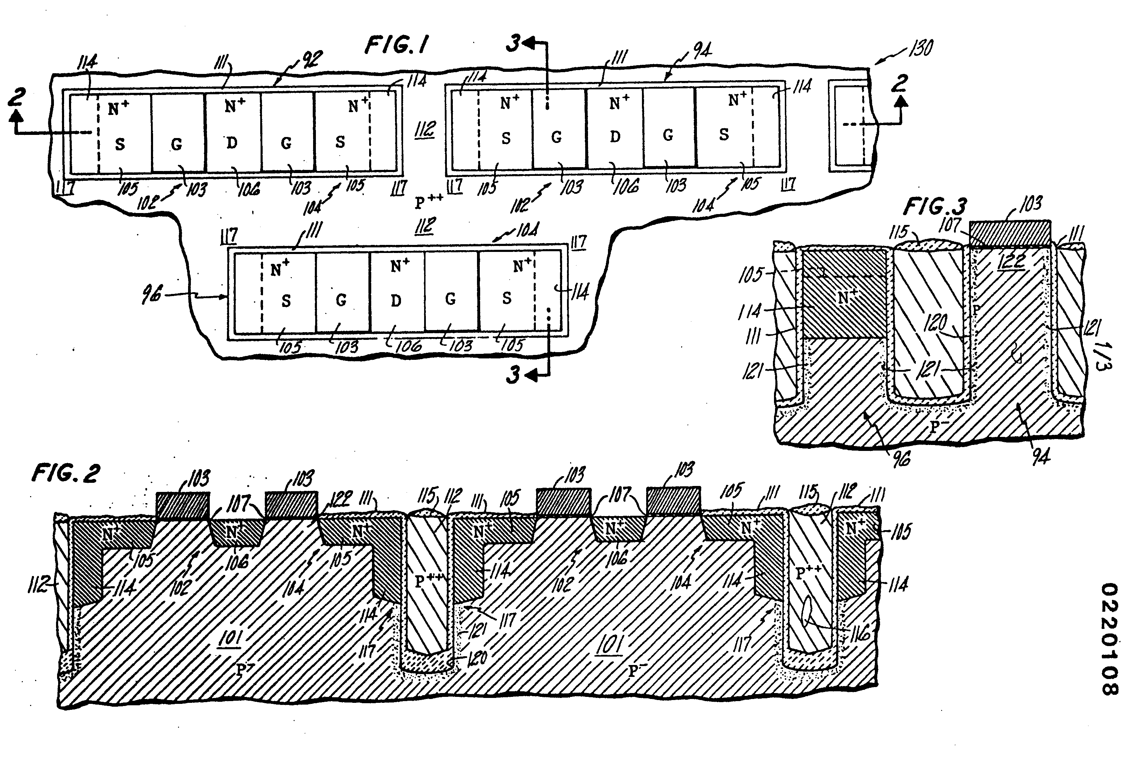

Referring now to Fig. 1, there is shown in top view a portion of an integrated circuit constructed according to the invention. This particular circuit happens to be a portion of a memory cell array, but the principles of the invention may be applied to any other form of integrated circuit. Three "islands" referred to by numerals 92, 94 and 96 are located in a "sea" of polysilicon denoted by the numeral 112, each island being surrounded by a layer of silicon oxide 111. The invention is addressed at preventing the formation of parasitic channels between these islands as well as between individual elements within an island; such as the drain and source of a transistor. The particular circuit elements located on each island are a pair of transistors 102 and 104 sharing a common drain 106 and each having a separate source 105. Each source is connected to a capacitor 117 having a first plate 114 formed vertically into the substrate and a ground plate which is formed by polysilicon 112. Connections to the transistors are omitted to provide greater clarity in the drawing, as is a layer of oxide 111 over sources 105.

Referring now to Fig. 2, there is shown a cross section through line 2-2 of Fig. 1. This cross section extends through islands 92 and 94, separated by a trench 120 in the center of the drawing. The same two transistors 102 and 104 in each island formed in substrate 101 are shown with capacitor plates 114 on either side of trench 120. Trench 120 is lined with oxide 111 which also extends over source 105 and the top of capacitor plate 114. Trench 120 is filled with polysilicon 112 which is heavily doped, as is indicated by the $P^{++}$ symbol. The polysilicon is protected by a field oxide 115. Two capacitors, referred to by the general numeral 117, are formed, sharing polysilicon 112 as a common ground plate and having oxide insulation 111 on either side of polysilicon 112. The two inner plates 114 complete the structure of transistors 117. Plates 114 are electrically connected by common doping to sources 105.

- 4 -

There is a further element in the cross section, indicated by the numeral 121, comprising a doped region having the same polarity as the doping in trench 120 and surrounding trench 120, not only in the plane shown in the cross section but on the surface of the "sea" of polysilicon extending around and facing each island that is above and below the plane of Fig. 2. Doped area 121 is not shown as extending into plates 114 of capacitors 117 because the amount of doping is insufficient to change the type of impurity of plates 114. The concentration at the edge of oxide 111 is merely reduced slightly.

Another side view of the array of islands shown in Fig. 1, looking along line 3-3 in Fig. 1, is shown in Fig. 3. There, the section is taken through one of plates 114 in island 96 and through gate 103 of island 94, showing the bottom of source 105, the plate 114 itself, the oxide 111 that is formed on either side of islands 94 and 96 and extends down into the trench. Note that region 121 is shown as extending only up to capacitor plate 114 in island 96, but extends up to gate oxide 109 in island 94. This region 121 serves an equivalent function to a conventional field implant by raising the threshold of formation of parasitic channels. These channels can form between islands or along the surface of oxide 111 that faces the island. In particular, a channel could be formed in region 122, on the vertical surface of oxide 111 that is below the gate of a transistor and between the source and drain, thus effectively short-circuiting the transistor. In planar circuits, the field implant suppresses the formation of parasitic channels. It has been a drawback of trench isolation methods in the prior art that there has been no effective way to provide the same suppression of the parasitic channels, and this is the problem that the present invention solves. The concentration of doped region 121 is indicated by P indicating a light concentration of approximately $5 \times 10^{16}$ ions per cc, near the vertical silicon surface in the substrate 101 outside the $N^+$ areas, which is formed by diffusion of the heavily doped impurities within polysilicon 112 through oxide 111 and into substrate 101 surrounding the trench. It is necessary, of course, that the impurity used in trench 112 be capable of diffusing through thin oxide. Boron has that property and is a material well known in the art.

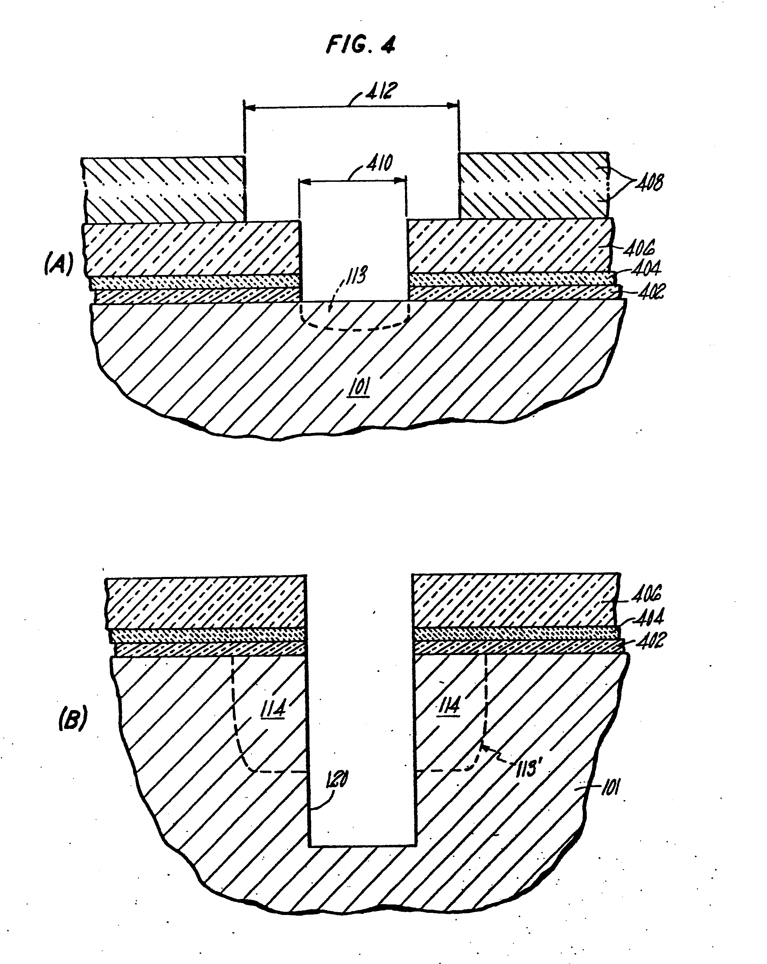

Further details of the process steps can be seen in Figs. 4a and 4b. Fig. 4a illustrates a step in an optional version of the invention in which an aperture having a width indicated by the arrow labeled 410, penetrates a series of layers comprising oxide layer 402 having an illustrative thickness of 500 angstroms, nitride layer 404 having an illustrative thickness of 1000 angstroms, and an oxide layer 406 having an illustrative thickness of 5000 angstroms. A further photoresist layer 408 having an aperture indicated by the arrow labeled 412 is placed above oxide layer 406 in order to define an ion implant area. Aperture 412 is made oversized in order to provide for alignment tolerance. A dose of phosphorus is implanted through aperture 410 in the region indicated by the numeral 113 with an illustrative concentration of $10^{15}/\text{centimeter}^2$. Aperture 410 may be formed by any

- 6 -

convenient means known in the art, such as by reactive ion etching (RIE). In Fig. 4b, the results of a diffusion drive at a temperature of between 1,100 and 1,150 degrees centigrade for several hours has expanded area 113 into area 113' having a nominal width of 2.1 microns and a nominal depth of 2.5 microns. This area 113', which will become plates 114 at capacitor 117, is shown as being penetrated by trench 120 which is formed by a second step of reactive ion etching to a depth of between 3 and 3.5 microns. In the course of this second RIE step, part of oxide layer 406 is consumed. Layer 406 need not be oxide, but may be any material that will protect the nitride layer during the RIE step. The thickness of layer 406 should, of course, be taken together with the properties of the particular RIE process being used so that the nitride layer 404 is protected during this step. The invention is not limited to circuits that employ a capacitor adjacent to the trench and any circuit element may be in that position.

After trench 120 is cut, there are further steps of growing a layer of oxide on the interior surface of trench 120 to a nominal thickness of approximately 400 angstroms; stripping the oxide by a conventional wet etch process and growing a final layer of oxide to a nominal thickness of 100 angstroms.

The trench is then filled by doped polycrystalline silicon formed in a standard process using, for example $SiH_4$ together with $B_2H_6$ at standard temperatures and pressures well known to those skilled in the art. The concentration of boron dopant in the polycrystalline silicon should be about $5x10^{18}$

per cc (typically a factor of 100 greater than the substrate concentration). In filling such a deep, narrow trench, there may well develop voids 116 within polysilicon 112. That is no problem in this invention because the only requirement for polysilicon 112 is that it form a conductive layer in the region of capacitor 117 and have a sufficient amount of polycrystalline silicon in the bottom of the trench to drive a sufficient quantity of boron in to form doped layer 121. This amount is non-critical, an advantageous feature of this invention.

After the doped polycrystalline layer has been deposited throughout the trench region, the portion of the polycrystalline silicon lying above the islands is etched away, as is the remainder of oxide layer 406. A field oxide region is then grown over polycrystalline silicon 112 to protect the trench and the remainder of the circuit elements on the island are formed in a conventional manner.

It is an advantageous feature of the invention that the doped polysilicon 112 in trench 120 is at the same potential as substrate 101, illustratively ground. There will often be small amounts of debris left from previous processing steps in the bottom of trench 120, which must have a small width to depth ratio in order to occupy as little room as possible. The debris could easily cause short circuits or interfere in some other way with the circuit. With the trench filling material of the same polarity and at the same potential as the substrate, any debris will be innocuous.

- 8 -

If a capacitor 117 is formed as shown in Fig. 2, then there will be more stress on oxide 111, for a given oxide thickness, when polysilicon 112 is grounded than if it were at Vcc/2, but maintaining capacitor plate 112 at some intermediate voltage would risk shorts to the substrate 101.

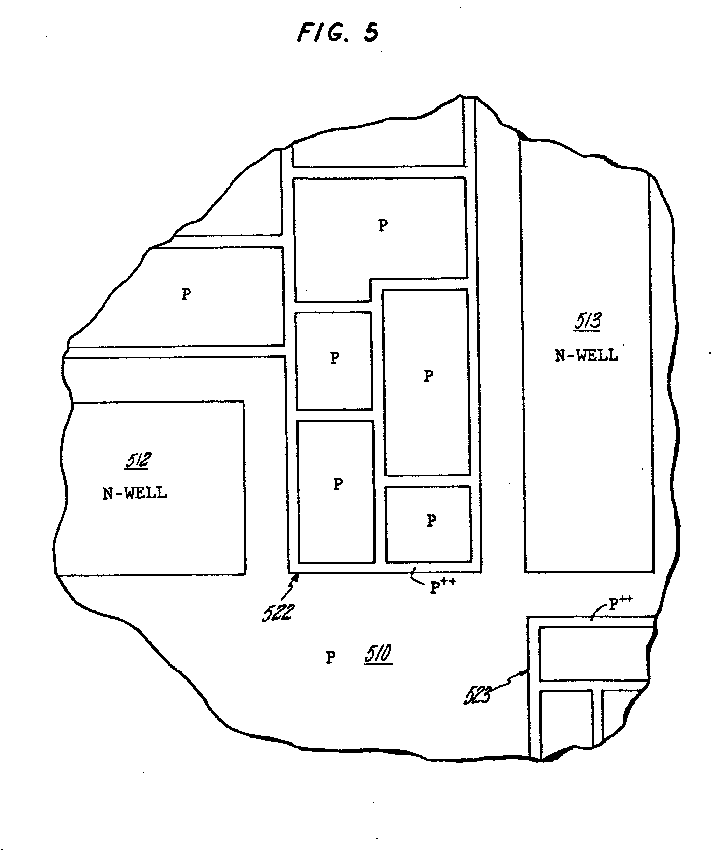

The application of the invention to a CMOS circuit is illustrated in Fig. 5, showing a top view of a P-doped epitaxial layer 510 containing N-wells 512 and 513, which are prepared conventionally. The N-wells contain circuits that are not indicated in the figure, since the invention is directed at isolation. Two networks of trenches 522 and 523, containing P-type polysilicon and formed as discussed above, are shown surrounding islands of P-type silicon containing any circuit elements that it is desirable to isolate. The contents of an island could be a single N-channel transistor or a group of N-channel transistors together with other elements, as illustrated in Figs. 1-3. For superior latchup protection, the depth of trenches 522 and 523 should be great enough to penetrate the up-diffusion from the substrate. No particular geometry or shape of the trench networks is required. Preferably, the trenches should all have the same width, so that the planarity of the circuit is not affected.

If desired, the circuit elements in the P-doped epitaxial layer could be isolated by conventional planar isolation, with the trenches reserved for a peripheral isolation and latchup protection. Such an arrangement would depend on a tradeoff between the additional complexity of using two isolation schemes and the reliability of the trench isolation process. Also, a corresponding network of trench using N-doped polysilicon (Phosporous-doped, say) could be formed within the N-wells. Care would have to be taken to avoid interaction between the N-doped trench filler and the P-doped substrate; and only very high-density circuits that have a great need for compact isolation or that have to employ trench capacitors together with transistors of both polarity would justify the use of trenches in the N-well.

A further advantageous feature of the invention is that, with polysilicon 112 doped with P-type material and plate 114 and transistor source 105 and drain 106, doped with N-type material, the effect of a pinhole or other defect in oxide 111 is reduced. It is well known that thinner oxides have more holes than thick ones and that the result of a hole is usually a short circuit that ruins the chip. For example, when a conventional five volt level is being stored in a memory cell, the bit line 106, source 105 and capacitor plate 114 of that cell will all be raised to five volts and there is great stress on oxide 111.

With this invention, if there is a pinhole through oxide 111 the N+ region will be at plus five volts and the $P^{++}$ region will be at ground. The region of the circuit around the pinhole will be a P-N diode, reverse-baised at five volts, that will not conduct current. Short circuits through oxide 111 are thus "self-healing", resulting in greater yield than would be the case if a different combination of materials were used.

- 10 -

The invention has been illustrated in the context of a conventional N-channel process and a DRAM memory cell. Those skilled in the art will readily be able to apply the principles of this invention to other circuits beside DRAMs, and to other combinations of voltage levels and doping materials. The point in the process sequence at which the trench is cut and filled is not critical. Preparation of transistor substrates by ion implantation of the channel and other steps up to forming the gates and the sources and drains may be done before or after the trench is cut and filled. The trench must be completed, of course, before interconnections are made between the islands.

- 11 -

## Claims

1. An intermediate isolation method in the fabrication of a silicon integrated circuit containing a plurality of circuit elements formed in a semiconductor substrate having a substrate conductivity type, at least two of which circuit elements have circuit element locations that are isolated from one another by a trench containing insulating materials, comprising the steps of:

cutting a trench into said substrate between said at least two circuit element locations, thereby forming a trench wall on that surface of said trench extending into said substrate from each of said circuit element locations;

growing a wall layer of silicon dioxide on said trench wall;

filling said trench with polycrystalline silicon filler, characterized in that:

said polycrystalline filler is heavily doped with a trench dopant material of the same conductivity type as said substrate conductivity type and having the capability of diffusing through thin layers of silicon dioxide; and

said isolation method further comprises the step of heating said substrate to a predetermined temperature for a predetermined time sufficient to diffuse a predetermined quantity of said trench dopant material thorugh said wall layer of silicon dioxide to form a channel stop region in that portion of said silicon substrate abutting said trench wall.

- 12 -

2. A method according to claim 1, in which said trench surrounds at least one circuit element location and comprising the further steps of forming an insulated gate field effect transistor on said circuit element location, said transistor being bounded by said trench on first and second sides, thereby defining first and second inner trench surfaces, extending into said substrate below a channel region of said transistor, whereby that portion of said channel stop region below said channel region of said transistor serves to reduce the leakage current through said transistor.

3. A method according to claim 2, in which said further steps of forming said transistor are performed before said trench is cut.

4. A method according to claim 2, in which said further steps of forming said transistor are performed after said trench is cut.

5. A method according to claim 2, in which said substrate is doped with a P-type dopant to a substrate concentration;
said trench dopant material is boron;
said polycrystalline filler is doped with a concentration approximately two orders of magnitude greater than said substrate concentration; and
said wall layer has a thickness of approximately 100 angstroms.

6.   A method according to claim 1, further including the preliminary steps of:

forming a first layer of silicon dioxide on a top surface of at least one circuit element location;

depositing a layer of silicon nitride on said first layer of silicon dioxide;

depositing a protective layer on said layer of silicon nitride;

cutting an implant aperture, in a predetermined location adjacent said predetermined circuit element location, through said protective layer, said silicon nitride layer and said first silicon dioxide layer to said substrate;

implanting a predetermined dose of ions on conductivity type opposite to said substrate conductivity type;

diffusing said dose of ions into said substrate by heating said substrate to a predetermined temperature for a predetermined time such that a substantial concentration of said ions of said opposite conductivity type extends a predetermined distance from said implant aperture, whereby that portion of said dose of ions extending in said substrate below said predetermined circuit element location forms one plate of a capacitor, the other plate of which is formed by said heavily doped polycrystalline filler.

7. A method in the fabrication of a silicon CMOS integrated circuit comprising the steps of:

forming at least one well of a second conductivity type in a substrate of a first conductivity type, thereby defining at least one well substrate and a field region outside said at least one well;

cutting a trench into said substrate between at least two circuit element locations in said field region, thereby forming a trench wall on that surface of said trench extending into said substrate from each of said circuit element locations;

growing a wall layer of silicon dioxide on said trench wall;

filling said trench with a heavily doped polycrystalline silicon filler of the same conductivity type as said substrate conductivity type and having the capability of diffusing through thin layers of silicon dioxide;

heating said substrate to a predetermined temperature for a predetermined time sufficient to diffuse a predetermined quantity of said trench dopant material through said wall layer of silicon dioxide to form a channel stop region in that portion of said silicon substrate abutting said trench wall.

8. A method according to claim 7, further comprising the steps of:

cutting a well trench into said well between at least two circuit element locations in said well, thereby forming a well trench wall on that surface of said well trench extending into said well substrate from each of said circuit element locations;

growing a well wall layer of silicon dioxide on said well trench wall;

filling said trench with a heavily doped polycrystalline silicon filler, doped with a well trench dopant material of said second conductivity type and having the capability of diffusing through thin layers of silicon dioxide;

heating said substrate to a predetermined temperature for a predetermined time sufficient to diffuse a predetermined quantity of said well trench dopant material through said well wall layer of silicon dioxide to form a channel stop region in that portion of said well substrate abutting said well trench wall.

9. A method according to claim 8, in which said trench dopant material and said well trench dopant material are diffused simultaneously.

FIG.1

114  111  92  3  111  94  130

114  114

2  N+  N+  N+  N+  N+  N+  114  2

S  G  D  G  S  112  S  G  D  G  S

117  105  103  106  103  105  117  117  105  103  106  103  105  117
102  104  P++  102  104

117  111  112  104  117  FIG.3  103

N+  N+  N+  115  107  111

96  S  G  D  G  S  114  105  N+  122

105  103  106  103  105  114  120  121

3  111  121  121

121  96  94

FIG.2  103  103  107  122  111  115  112  111  105  103  107  103  105  111  115  112  111

N+  N+  N+  N+  N+  N+  N+  105

112  114  105  102  106  104  105  114  P++  114  102  106  104  114  P++  114

101  117  121  117  101  117  116

P−  114  120  P−

0220108

1/3

**FIG. 4**

(A)

(B)

# FIG. 5

**512** N-WELL

**513** N-WELL

P

P

P

P

P

P

P

P$^{++}$

522

510

P

523

P$^{++}$